(19) Europäisches Patentamt
European Patent Office
Office européen des brevets

(11) **EP 4 244 639 B1**

(12) **EUROPÄISCHE PATENTSCHRIFT**

(45) Veröffentlichungstag und Bekanntmachung des Hinweises auf die Patenterteilung:
**11.12.2024   Patentblatt 2024/50**

(21) Anmeldenummer: **21799294.0**

(22) Anmeldetag: **28.10.2021**

(51) Internationale Patentklassifikation (IPC):
**H02P 6/04** (2016.01)        **G01R 31/34** (2020.01)

(52) Gemeinsame Patentklassifikation (CPC):
**G01R 31/343; H02P 6/04**

(86) Internationale Anmeldenummer:
**PCT/EP2021/080004**

(87) Internationale Veröffentlichungsnummer:
**WO 2022/101026 (19.05.2022 Gazette 2022/20)**

(54) **VERFAHREN ZUR BESTIMMUNG VON VERLUSTEN, UMRICHTER UND VERFAHREN ZUM BETREIBEN EINES UMRICHTERS**

METHOD FOR DETERMINING LOSSES, CONVERTER, AND METHOD FOR OPERATING A CONVERTER

PROCÉDÉ DE DÉTERMINATION DE PERTES, CONVERTISSEUR, ET PROCÉDÉ D'EXPLOITATION D'UN CONVERTISSEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.11.2020   DE 102020006899**

(43) Veröffentlichungstag der Anmeldung:
**20.09.2023   Patentblatt 2023/38**

(73) Patentinhaber: **SEW-EURODRIVE GmbH & Co. KG 76646 Bruchsal (DE)**

(72) Erfinder: **KRÄMER, Andre 75015 Bretten (DE)**

(56) Entgegenhaltungen:
• HESEDING JOHANNES ET AL: "Estimation of losses in permanent magnet synchronous machines caused by inverter voltage harmonics in driving cycle operation", 2016 18TH EUROPEAN CONFERENCE ON POWER ELECTRONICS AND APPLICATIONS (EPE'16 ECCE EUROPE), JOINTLY OWNED BY IEEE-PELS AND EPE ASSOCIATION, 5 September 2016 (2016-09-05), pages 1 - 9, XP032985308, DOI: 10.1109/EPE.2016.7695591
• VAN KHANG HUYNH ET AL: "Investigation and reduction of losses on inverter-fed induction motors", 2017 19TH EUROPEAN CONFERENCE ON POWER ELECTRONICS AND APPLICATIONS (EPE'17 ECCE EUROPE), JOINTLY OWNED IEEE-PELS AND EPE ASSOCIATION, 11 September 2017 (2017-09-11), XP033250597, DOI: 10.23919/EPE17ECCEEUROPE.2017.8099215

**Beschreibung**

Die Erfindung betrifft ein Verfahren zur Bestimmung von Verlusten, Umrichter und Verfahren zum Betreiben eines Umrichters.

Es ist allgemein bekannt, dass mittels der Bestimmung von Verlusten Verbesserungen bei Planungen von Anlagen erreichbar sind.

**Aus der XP 032985308 ist als nächstliegender Stand der Technik ein Verfahren zum Schätzen der Verluste bei Synchronmotoren bekannt.**

**Aus der XP 033250597 ist eine Reduzierung von Verlusten bei einem umrichtergespeisten Elektromotoren bekannt.**

Der Erfindung liegt daher die Aufgabe zugrunde, eine Verlustbestimmung zu vereinfachen, insbesondere bezüglich des Aufwands der Bestimmung.

Erfindungsgemäß wird die Aufgabe bei dem Verfahren nach den in Anspruch 1 und bei dem Umrichter nach den in Anspruch 7 angegebenen Merkmalen gelöst.

Wichtige Merkmale der Erfindung bei dem Verfahren sind, dass das Verfahren zur Bestimmung von Verlusten, insbesondere eines umrichterbedingten Verlustanteils der gesamten Verluste, von zumindest einem ersten und einem zweiten Antrieb vorgesehen ist, wobei der erste Antrieb einen von einem pulsweitenmoduliert betriebenen Umrichter gespeisten ersten Motor, also Drehstrom-Elektromotor, insbesondere Synchronmotor, aufweist,

wobei der zweite Antrieb einen von dem Umrichter gespeisten zweiten Motor, also Drehstrom-Elektromotor, insbesondere Synchronmotor, aufweist,

wobei der erste Motor eine Wicklungszahl w_1 und einen Drahtquerschnitt A1 seines Wicklungsdrahts seiner Statorwicklung aufweist und der zweite Motor eine Wicklungszahl w_2 und einen Drahtquerschnitt A2 seines Wicklungsdrahts seiner Statorwicklung aufweist,

wobei der Drahtquerschnitt A2 dem Produkt aus dem Drahtquerschnitt A1 und dem Quotienten aus der Wicklungszahl w_1 und der Wicklungszahl w_2 gleicht,

**wobei in einem ersten Verfahrensschritt** die Verluste $P_{HL\_1}$ des ersten Antriebs bestimmt werden gemäß

$$P_{HL\_1} = 3 \cdot \frac{U_{DC}^2}{w\_1^2} \cdot g^*_{f_{PWM}}(m) \,,$$

wobei w_1 die Wicklungszahl des ersten Motors ist,

wobei $U_{DC}$ die Zwischenkreisspannung des Umrichters ist,

wobei $g^*_{f_{PWM}}(m) = \sum_i \sum_j h(fi,j) \cdot g^2_{i,j}(m)$ gilt und $g^*_{f_{PWM}}(m)$ als eine charakteristische Funktion bezeichenbar ist,

wobei i und j die Frequenzen $f_{i,j}$ , insbesondere die nicht verschwindenden Frequenzen $f_{i,j}$ , im Fourierspektrum der Versorgungsspannung des ersten Motors nummerieren, insbesondere die erfasst wird,

wobei $h(fi,j) = \frac{\cos\phi}{|Z|}(fi,j) \cdot w_1^2$ ist,

wobei cos (Φ) der von den Frequenzen $f_{i,j}$ abhängige Leistungsfaktor und Z die von den Frequenzen $f_{i,j}$ abhängige Impedanz des ersten Motors sind und in Abhängigkeit der Frequenzen $f_{i,j}$ erfasst werden,

wobei $g_{i,j}(m)$ eine normierte Ausgangsspannung des Umrichters, insbesondere in Abhängigkeit des Modulationsgrades $m$, bei der jeweiligen Frequenz $f_{i,j}$ ist,

wobei die normierte Ausgangsspannung $g_{i,j}(m)$ aus

$$U_{i,j} = U_{DC} \cdot g_{i,j}(m)$$

bestimmt wird,

wobei die Spannungsanteile U$_{i,j}$ aus dem Fourierspektrum der Versorgungsspannung des Motors bestimmt werden,

**wobei in einem zweiten Verfahrensschritt**

die Verluste P$_{HL\_2}$ des zweiten Antriebs bestimmt werden gemäß

$$P_{HL\_2} = 3 \cdot \frac{U_{DC}^2}{w\_2^2} \cdot g_{f_{PWM}}^*(m)$$

wobei w_2 die Wicklungszahl des zweiten Motors ist,

insbesondere wobei als charakteristische Funktion $g_{f_{PWM}}^*(m)$

die für den ersten Motor bestimmte charakteristische Funktion $g_{f_{PWM}}^*(m)$ verwendet wird.

Von Vorteil ist dabei, dass die charakteristische Funktion nur für den ersten Motor aus den messtechnisch erfassten Größen bestimmt werden muss. Denn für den zweiten Motor genügt die Berechnung unter Berücksichtigung der Zwischenkreisspannung des Umrichters und der Wicklungszahl des zweiten Motors.

Auf diese Weise ist für den zweiten Motor kein besonderer Aufwand notwendig, sondern eine schnelle und wenig aufwendige Berechnung ausführbar. Statt des zweiten Motors sind auch andere Motoren einer Baureihe von Motoren verwendbar, die sich vom ersten Motor ebenfalls nur in der wicklungszahl und dem Drahtquerschnitt unterscheiden.

Die Erfindung weist zwar auch geringfügige Abweichungen zu den durch Messungen bestimmbaren Verlusten auf; jedoch ist die erreichbare Abweichung unwesentlich. Somit ist eine schnelle und wenig aufwendige Bestimmung der Verluste erreichbar.

Wichtig ist bei der Erfindung auch, dass der Drahtquerschnitt umgekehrt proportional zur Wicklungszahl ist und somit der Ohm'sche Gleichstrom-Widerstand der Wicklung als proportional zum Quadrat der Anzahl der Windungen angenommen werden darf. Durch diesen Effekt ist die charakteristische Funktion bei beiden Motoren zur Bestimmung der Verluste verwendbar.

Die beiden Motoren sind als Drehstrommotoren ausgeführt. Vorzugsweise sind die Motoren Synchronmotoren.

Bei einer vorteilhaften Ausgestaltung wird statt des Quotienten aus Leistungsfaktor und Betrag der Impedanz der Quotient aus dem Wirkwiderstand und dem Quadrat der Impedanz verwendet. Von Vorteil ist dabei, dass entsprechende Messmethoden, insbesondere Bestimmung von Spannungswerten, Stromwerten, Effektivwerten von Strom und Spannung der Motorphasen, verwendbar sind.

Bei einer vorteilhaften Ausgestaltung sind der erste und der zweite Motor ausgenommen die Wicklungszahl und den Drahtquerschnitt baugleich, insbesondere identisch, zueinander ausgeführt. Von Vorteil ist dabei, dass eine einfache Bestimmung ermöglicht ist.

Bei einer vorteilhaften Ausgestaltung weist der Stator des jeweiligen Motors ein Blechpaket mit nach radial innen hervorragenden Zähnen auf, wobei jeder Zahn mit einer Anzahl von Windungen einer Wicklung bewickelt ist, wobei die Anzahl die Wicklungszahl des Motors ist. Von Vorteil ist dabei, dass die Motoren als Synchronmotoren mit Zahnspulenwicklung ausführbar sind.

Bei einer vorteilhaften Ausgestaltung unterscheidet sich die Wicklungszahl w_1 von der Wicklungszahl w_2. Von Vorteil ist dabei, dass die Verlustbestimmung einfach ausführbar ist.

Bei einer vorteilhaften Ausgestaltung nummerieren i und j diejenigen Frequenzen f$_{i,j}$ des Fourierspektrums der Versorgungsspannung des ersten Motors, bei denen nicht verschwindende Spannungsanteile U$_{i,j}$ erfasst werden. Von Vorteil ist dabei, dass eine einfache Bestimmung ausführbar ist.

Wichtige Merkmale bei dem Umrichter zur Durchführung eines vorgenannten Verfahrens sind, dass die Bestimmung der Verluste des zweiten Motors von der Signalelektronik des Umrichters ausgeführt wird, insbesondere ausführbar ist.

Von Vorteil ist dabei, dass die Bestimmung von Verlusten im laufenden Betrieb ausführbar. Bei einer vorteilhaften Ausgestaltung ist die charakteristische Funktion in einem Speicher des Umrichters abgespeichert und der Umrichter weist ein Mittel zur Erfassung der Zwischenkreisspannung des Umrichters auf. Von Vorteil ist dabei, dass die charakteristische Funktion für alle Motoren verwendbar ist. Wichtige Merkmale bei dem Verfahren zum Betreiben eines vorgenannten Umrichters sind, dass die in Abhängigkeit der erfassten Zwischenkreisspannung des Umrichters bestimmten Verluste in einem Temperaturmodell der Motorführung des Umrichters verwendet werden. Von Vorteil ist dabei, dass im laufenden Betrieb die bestimmten Verluste verwendbar sind.

Weitere Vorteile ergeben sich aus den Unteransprüchen.

Die Erfindung wird nun näher erläutert:

Zur Bestimmung von Verlusten eines ersten Antriebs, aufweisend einen von einem ersten Umrichter gespeisten ersten Drehstrom-Elektromotor, insbesondere Synchronmotor, wird der Elektromotor zunächst vermessen.

Die genannten Verluste beziehen sich dabei nur auf die umrichterbedingten Verluste, die selbstverständlich nur einen Anteil des jeweiligen Gesamtverlusts darstellen.

Für die Verluste $P_{HL}$ eines Antriebs gilt wegen der Frequenzabhängigkeit allgemein

$$P_{HL} = 3 \cdot \int_{f > f_1}^{\infty} \frac{\cos\phi}{|Z|}(f) \cdot U^2(f)\, df$$

, wobei Z die Impedanz der Statorwicklung des Elektromotors ist, R der Wirkwiderstand der Statorwicklung, U die Versorgungsspannung des Motors, cos ($\Phi$) der Leistungsfaktor und $f_1$ die Grundfrequenz ist.

Bei der Vermessung wird der Quotient $\frac{R}{Z^2} = \frac{\cos\phi}{|Z|}$ für verschiedene Frequenzen $f_{i,j}$ bestimmt, wobei i und j die Frequenzen nummerieren, wobei die durchnummerierten Frequenzen sich gemäß $f_{i,j} = j \cdot f_{PWM} \pm i \cdot f_1$ aus der Pulsweitenmodulationsfrequenz $f_{PWM}$, der Grundfrequenz $f_1$ des Umrichters ergeben. Dabei gilt zusätzlich i+j = 2h+1, wobei h eine natürliche Zahl ist.

Zwar wäre eine Bestimmung der Verluste möglich gemäß:

$$P_{HL} = 3 \cdot U_{DC}^2 \cdot \sum_i \sum_j \frac{\cos\phi}{|Z|}(f_{i,j}) \cdot g_{i,j}^2(m)$$

wobei $U_{DC}$ die Zwischenkreisspannung und $g_{i,j}(m)$ die normierte Ausgangsspannung des Umrichters in Abhängigkeit des Modulationsgrades m bei der Frequenz $f_{i,j}$ ist.

Aus dem Fourierspektrum der Versorgungsspannung des Motors sind die Spannungsanteile $U_{i,j}$ bestimmbar, die bei den jeweiligen Frequenzen $f_{i,j}$ auftreten.

Die normierte Ausgangsspannung $g_{i,j}(m)$ ist somit bestimmbar aus

$U_{i,j} = U_{DC} \cdot g_{i,j}(m)$. Dabei ist

$$m = \frac{2 \cdot \sqrt{2} \cdot U_S}{U_{DC}}$$

, wobei $U_S$ die Strangspannung der Statorwicklung ist.

Bei den Frequenzen $f_{i,j}$ ist gemäß $\frac{R}{Z^2} = \frac{\cos\phi}{|Z|}$ der Quotient aus dem Leistungsfaktor und dem Betrag der Impedanz zu bestimmen. Zusammen mit den aus dem Fourierspektrum bestimmten Spannunganteilen $U_{i,j}$ ist somit die obengenannte Doppelsumme bestimmbar.

Allerdings müsste diese Bestimmung jeden anderen Motor ebenfalls ausgeführt werden, da diese anderen Motoren sich vom ersten Motor durch ihre Wicklungszahl und den Drahtquerschnitt unterscheiden.

Jeder der Motoren weist ein Statorblechpaket auf, das nach radial innen hervorragende Zähne aufweist, wobei eine Anzahl w von Wicklungen aufweist. Vorzugsweise sind die Zähne in Umfangsrichtung voneinander gleichmäßig beabstandet.

Die Wicklungszahl w ist also charakteristisch für den jeweiligen Motor. Der Drahtquerschnitt wird umgekehrt proportional zur Wicklungszahl gewählt.

Erfindungsgemäß wird vorteiligerweise die Bestimmung der Verluste ausgeführt gemäß:

$$P_{HL} = 3 \cdot \frac{U_{DC}^2}{w^2} \cdot g_{f_{PWM}}^*(m) \,,$$

wobei $g_{f_{PWM}}^*(m) = \sum_i \sum_j h(f) \cdot g_{i,j}^2(m)$

$h(f) = \frac{\cos \phi}{|Z|}(f) \cdot w^2$

und

gilt.

Somit genügt die Bestimmung von $g_{f_{PWM}}^*(m)$, insbesondere für eine vorgegebene Grundfrequenz $f_1$, um eine charakteristische Funktion für den ersten Antrieb zu bestimmen.

Für alle Motoren ist somit die charakteristische Funktion $g_{f_{PWM}}^*(m)$ gleich.

Daher ist die Bestimmung der Verluste für einen jeweiligen gemäß

$$P_{HL} = 3 \cdot \frac{U_{DC}^2}{w^2} \cdot g_{f_{PWM}}^*(m)$$

Rein rechnerisch möglich, da die charakteristische Funktion $g_{f_{PWM}}^*(m)$ nicht noch einmal bestimmt werden muss.

Vorteil der Erfindung ist daher, dass umrichterbedingte Verluste vom ersten Motor auf entsprechende Verluste bei den anderen Motoren mit anderen Windungszahlen umgerechnet werden können, ohne dass weitere messtechnische Bestimmungen notwendig sind.

Vorzugsweise ist dieses Umrechnen in der Signalelektronik des Umrichters hinterlegbar oder ausführbar, um beispielsweise Verbesserungen von zur Motorsteuerung verwendeter Temperaturmodelle und/oder Bestimmungen hinsichtlich Energieeffizienz zu bewirken.

Die Bestimmung von Verlusten ist aber auch in Projektierungen von Anlagen mit einem Antrieb verwendbar, wobei nun die Berücksichtigung der Verluste vereinfacht ermöglicht ist. Beispielsweise ist unter mehreren verfügbaren Antrieben derjenige Antrieb für die Anlage heraussuchbar, der die geringsten Verluste aufweist.

**Bezugszeichenliste**

$g_{f_{PWM}}^*(m)$ charakteristische Funktion
$g_{i,j}(m)$ normierte Ausgangsspannung
cos (Φ) Leistungsfaktor
$f_1$ Grundfrequenz
$U_{DC}$ Zwischenkreisspannung des Umrichters
$U_S$ Strangspannung

**Patentansprüche**

1.  Verfahren zur Bestimmung von Verlusten, insbesondere eines umrichterbedingten Verlustanteils der gesamten Verluste, von zumindest einem ersten und einem zweiten Antrieb,

> wobei der erste Antrieb einen von einem pulsweitenmoduliert betriebenen Umrichter gespeisten ersten Motor, also Drehstrom-Elektromotor, insbesondere Synchronmotor, aufweist,
> wobei der zweite Antrieb einen von dem Umrichter gespeisten zweiten Motor, also Drehstrom-Elektromotor, insbesondere Synchronmotor, aufweist,
> wobei der erste Motor eine Wicklungszahl w_1 und einen Drahtquerschnitt A1 seines Wicklungsdrahts seiner Statorwicklung aufweist und der zweite Motor eine Wicklungszahl w_2 und einen Drahtquerschnitt A2 seines Wicklungsdrahts seiner Statorwicklung aufweist,
wobei der Drahtquerschnitt A2 dem Produkt aus dem Drahtquerschnitt A1 und dem Quotienten aus der Wicklungszahl w_1 und der Wicklungszahl w_2 gleicht,
**wobei in einem ersten Verfahrensschritt** die Verluste $P_{HL\_1}$ des ersten Antriebs bestimmt werden gemäß

$$P_{HL\_1} = 3 \cdot \frac{U_{DC}^2}{w\_1^2} \cdot g^*_{f_{PWM}}(m) \,,$$

wobei w_1 die Wicklungszahl des ersten Motors ist,
wobei $U_{DC}$ die Zwischenkreisspannung des Umrichters ist,
wobei $g^*_{f_{PWM}}(m) = \sum_i \sum_j h(fi,j) \cdot g^2_{i,j}(m)$ gilt und $g^*_{f_{PWM}}(m)$ als eine charakteristische Funktion bezeichenbar ist,
wobei i und j die Frequenzen $f_{i,j}$, insbesondere die nicht verschwindenden Frequenzen $f_{i,j}$, im Fourierspektrum der Versorgungsspannung des ersten Motors nummerieren, insbesondere die erfasst wird,
wobei $h(fi,j) = \frac{\cos \phi}{|Z|}(fi,j) \cdot w_1^2$ ist,
wobei cos (Φ) der von den Frequenzen $f_{i,j}$ abhängige Leistungsfaktor und Z die von den Frequenzen $f_{i,j}$ abhängige Impedanz des ersten Motors sind und in Abhängigkeit der Frequenzen $f_{i,j}$ erfasst werden,
wobei $g_{i,j}(m)$ eine normierte Ausgangsspannung des Umrichters, insbesondere in Abhängigkeit des Modulationsgrades m, bei der jeweiligen Frequenz $f_{i,j}$ ist,
wobei die normierte Ausgangsspannung $g_{i,j}(m)$ aus

$$U_{i,j} = U_{DC} \cdot g_{i,j}(m)$$

bestimmt wird,
wobei die Spannungsanteile $U_{i,j}$ aus dem Fourierspektrum der Versorgungsspannung des Motors bestimmt werden,
**wobei in einem zweiten Verfahrensschritt**
die Verluste $P_{HL\_2}$ des zweiten Antriebs bestimmt werden gemäß

$$P_{HL\_2} = 3 \cdot \frac{U_{DC}^2}{w\_2^2} \cdot g^*_{f_{PWM}}(m)$$

wobei w_2 die Wicklungszahl des zweiten Motors ist,
insbesondere wobei als charakteristische Funktion $g^*_{f_{PWM}}(m)$
die für den ersten Motor bestimmte charakteristische Funktion $g^*_{f_{PWM}}(m)$ verwendet wird.

2. Verfahren nach Anspruch 1,
   **dadurch gekennzeichnet, dass**
   statt des Quotienten aus Leistungsfaktor und Betrag der Impedanz der Quotient aus dem Wirkwiderstand und dem Quadrat der Impedanz verwendet wird.

3. Verfahren nach einem der vorangegangenen Ansprüche,
   **dadurch gekennzeichnet, dass**
   der erste und der zweite Motor ausgenommen die Wicklungszahl und den Drahtquerschnitt baugleich, insbesondere identisch, zueinander ausgeführt sind.

4. Verfahren nach einem der vorangegangenen Ansprüche,
   **dadurch gekennzeichnet, dass**

   der Stator des jeweiligen Motors ein Blechpaket mit nach radial innen hervorragenden Zähnen aufweist,

wobei jeder Zahn mit einer Anzahl von Windungen einer Wicklung bewickelt ist, wobei die Anzahl die Wicklungszahl des Motors ist.

5. Verfahren nach einem der vorangegangenen Ansprüche,
   **dadurch gekennzeichnet, dass**
   sich die Wicklungszahl w_1 von der Wicklungszahl w_2 unterscheidet.

6. Verfahren nach einem der vorangegangenen Ansprüche,
   **dadurch gekennzeichnet, dass**
   wobei i und j diejenigen Frequenzen $f_{i,j}$ des Fourierspektrums der Versorgungsspannung des ersten Motors nummerieren, bei denen nicht verschwindende Spannungsanteile $U_{i,j}$ erfasst werden.

7. Umrichter, konfiguriert **zur** Durchführung eines Verfahrens nach einem der Ansprüche 1 bis 6 oder nach dem Anspruch 9
   **dadurch gekennzeichnet, dass**

   die Bestimmung der Verluste des zweiten Motors von der Signalelektronik des Umrichters ausgeführt wird, insbesondere ausführbar ist,
   insbesondere wobei die Signalelektronik des Umrichters zur Bestimmung der Verluste des zweiten Motors geeignet ausgeführt ist.

8. Umrichter nach **Anspruch 7,**
   **dadurch gekennzeichnet, dass**

   die charakteristische Funktion in einem Speicher der Signalelektronik des Umrichters abgespeichert ist und der Umrichter ein Mittel zur Erfassung der Zwischenkreisspannung des Umrichters aufweist.

9. **Verfahrennach einem der Ansprüche** 1 bis 6, **dadurch gekennzeichnet, dass**
   die in Abhängigkeit der erfassten Zwischenkreisspannung des Umrichters bestimmten Verluste in einem Temperaturmodell der Motorführung des Umrichters verwendet werden.

**Claims**

1. Method for determining losses, in particular a converterrelated loss component of the total losses, of at least a first and a second drive,

   wherein the first drive comprises a first motor, i.e. a three-phase electric motor, in particular a synchronous motor, fed by a pulse-width-modulated converter,
   wherein the second drive comprises a second motor, i.e. a three-phase electric motor, in particular a synchronous motor, fed by the converter,
   wherein the first motor has a number of windings w_1 and a wire cross-section A1 of its winding wire of its stator winding, and the second motor has a number of windings w_2 and a wire cross-section A2 of its winding wire of its stator winding,
   wherein the wire cross-section A2 is equal to the product of the wire cross-section A1 and the quotient of the number of windings w_1 and the number of windings w_2,
   wherein in a first method step the losses $P_{HL\_1}$ of the first drive are determined according to

$$P_{HL\_1} = 3 \cdot \frac{U_{DC}^2}{w\_1^2} \cdot g^*_{f_{PWM}}(m),$$

wherein w_1 is the number of windings of the first motor,
wherein $U_{DC}$ is the DC link voltage of the converter,

wherein $g^*_{f_{PWM}}(m) = \sum_i \sum_j h(fi,j) \cdot g^2_{i,j}(m)$, and $g^*_{f_{PWM}}(m)$ can be designated as a characteristic function,

wherein i and j number the frequencies $f_{i,j}$, in particular the non-vanishing frequencies $f_{i,j}$, in the Fourier spectrum of the supply voltage of the first motor, in particular which is detected,
wherein

$$h(fi, j) = \frac{cos\phi}{[Z]}(fi, j) \cdot w_1^2,$$

wherein $cos(\Phi)$ is the power factor dependent on the frequencies $f_{i,j}$, and Z is the impedance of the first motor dependent on the frequencies $f_{i,j}$, and these are detected as a function of the frequencies $f_{i,j}$,
wherein $g_{i,j}(m)$ is a standardized output voltage of the converter, in particular as a function of the degree of modulation m, at the respective frequency $f_{i,j}$,
wherein the standardized output voltage $g_{i,j}(m)$ is determined from

$$U_{i,j} = U_{DC} \cdot g_{i,j}(m),$$

wherein the voltage components $U_{i,j}$ are determined from the Fourier spectrum of the supply voltage of the motor,
wherein in a second method step
the losses $P_{HL\_2}$ of the second drive are determined according to

$$P_{HL\_2} = 3 \cdot \frac{U_{DC}^2}{w\_2^2} \cdot g_{f_{PWM}}^*(m),$$

wherein w_2 is the number of windings of the second motor,

in particular wherein the characteristic function $g_{f_{PWM}}^*(m)$ determined for the first motor is used as the characteristic function $g_{f_{PWM}}^*(m)$.

2. Method according to claim 1,
**characterized in that**
the quotient of the effective resistance and the square of the impedance is used instead of the quotient of the power factor and the magnitude of the impedance.

3. Method according to any one of the preceding claims, **characterized in that**
the first and the second motor are of the same construction, in particular are identical to each other, apart from the number of windings and the wire cross-section.

4. Method according to any one of the preceding claims, **characterized in that**

the stator of each motor comprises a laminated core with radially inwardly projecting teeth,
wherein each tooth is wound with a number of turns of a winding, the number being the number of windings of the motor.

5. Method according to any one of the preceding claims, **characterized in that**
the number of windings w_1 differs from the number of windings w_2.

6. Method according to any one of the preceding claims, **characterized in that**
wherein i and j number those frequencies $f_{i,j}$ of the Fourier spectrum of the supply voltage of the first motor at which non-vanishing voltage components $U_{i,j}$ are detected.

7. Converter configured to carry out a method according to any one of claims 1 to 6 or according to claim 9,
**characterized in that**

the losses of the second motor are determined, in particular can be determined, by the signal electronics of the converter,
in particular wherein the signal electronics of the converter are suitable for determining the losses of the second motor.

8. Converter according to claim 7, **characterized in that**

the characteristic function is stored in a memory of the signal electronics of the converter,
and the converter has a means for detecting the DC link voltage of the converter.

9. Method according to any one of claims 1 to 6, **characterized in that**
the losses determined as a function of the detected DC link voltage of the converter are used in a temperature model of the motor control of the converter.


**Revendications**

1. Procédé de détermination de pertes, en particulier d'une partie, due à un onduleur, des pertes totales d'au moins un premier entraînement et un deuxième entraînement, dans lequel le premier entraînement présente un premier moteur alimenté par un onduleur à modulation de largeur d'impulsion, à savoir un moteur électrique triphasé, en particulier un moteur synchrone,

dans lequel le deuxième entraînement présente un deuxième moteur alimenté par l'onduleur, à savoir un moteur électrique triphasé, en particulier un moteur synchrone, dans lequel le premier moteur présente un nombre d'enroulements w_1 et une section de fil A1 de son fil d'enroulement de son enroulement statorique et le second moteur présente un nombre d'enroulements w_2 et une section de fil A2 de son fil d'enroulement de son enroulement statorique,
dans lequel la section de fil A2 est égale au produit de la section de fil A1 et au quotient du nombre d'enroulements w_1 et du nombre d'enroulements w_2,
dans lequel, dans une première étape de procédé, les pertes $P_{HL\_1}$ du premier entraînement sont déterminées comme suit

$$P_{HL\_1} = 3 \cdot \frac{U_{DC}^2}{w\_1^2} \cdot g_{f_{PWM}}^*(m)$$

dans lequel w_1 est le nombre d'enroulements du premier moteur,
dans lequel $U_{DC}$ est la tension de circuit intermédiaire de l'onduleur,

dans lequel $g_{f_{PWM}}^*(m) = \sum_i \sum_j h(fi,j) \cdot g_{i,j}^2(m)$ et $g_{f_{PWM}}^*(m)$ peut être considérée comme une fonction caractéristique,
dans lequel i et j numérotent les fréquences $f_{i,j}$, en particulier les fréquences $f_{i,j}$ qui ne disparaissent pas dans le spectre de Fourier de la tension d'alimentation du premier moteur, en particulier celle qui est enregistrée,

dans lequel $h(fi,j) = \frac{\cos \Phi}{|Z|}(fi,j) \cdot w_1^2$ ,
dans lequel cos (Φ) est le facteur de puissance dépendant des fréquences $f_{i,j}$ et Z est l'impédance du premier moteur dépendant des fréquences $f_{i,j}$ et cos (Φ) et Z sont enregistrés en fonction des fréquences $f_{i,j}$,
dans lequel $g_{i,j}(m)$ est une tension de sortie normalisée de l'onduleur, en particulier en fonction du degré de modulation m, pour la fréquence $f_{i,j}$ respective,
dans lequel la tension de sortie normalisée $g_{i,j}(m)$ est déterminée à partir de

$$U_{i,j} = U_{DC} \cdot g_{i,j}(m)$$

dans lequel les composantes de tension $U_{i,j}$ sont déterminées à partir du spectre de Fourier de la tension d'alimentation du moteur,
dans lequel, dans une seconde étape de procédé

les pertes $P_{HL\_2}$ du second entraînement sont déterminées comme suit

$$P_{HL\_2} = 3 \cdot \frac{U_{DC}^2}{w\_2^2} \cdot g_{f_{PWM}}^{*}(m)$$

dans lequel w_2 est le nombre d'enroulements du deuxième moteur,

en particulier dans lequel la fonction caractéristique $g_{f_{PWM}}^{*}(m)$ déterminée pour le premier moteur est utilisée comme fonction caractéristique $g_{f_{PWM}}^{*}(m)$.

**2.** Procédé selon la revendication 1,
**caractérisé en ce que**
le quotient de la résistance active et du carré de l'impédance est utilisé au lieu du quotient du facteur de puissance et de la quantité d'impédance.

**3.** Procédé selon l'une quelconque des revendications précédentes,
**caractérisé en ce que**
les premier et second moteurs sont de construction similaire, en particulier identique, à l'exception du nombre d'enroulements et de la section de fil.

**4.** Procédé selon l'une quelconque des revendications précédentes,
**caractérisé en ce que**

le stator du moteur respectif présente un empilage de tôles avec des dents radialement saillantes vers l'intérieur, dans lequel chaque dent est enroulée avec un certain nombre de spires d'un enroulement, dans lequel ledit nombre est le nombre d'enroulements du moteur.

**5.** Procédé selon l'une quelconque des revendications précédentes,
**caractérisé en ce que**
le nombre d'enroulements w_1 est différent du nombre d'enroulements w_2.

**6.** Procédé selon l'une quelconque des revendications précédentes,
**caractérisé en ce que**
i et j numérotent les fréquences $f_{i,j}$ du spectre de Fourier de la tension d'alimentation du premier moteur pour lesquelles des composantes de tension $U_{i,j}$ qui ne disparaissent pas sont enregistrées.

**7.** Onduleur configuré pour mettre en oeuvre un procédé selon l'une quelconque des revendications 1 à 6 ou selon la revendication 9,
**caractérisé en ce que**

la détermination des pertes du deuxième moteur est mise en oeuvre, en particulier peut être mise en oeuvre, par l'électronique de signal de l'onduleur,
en particulier dans lequel l'électronique de signal de l'onduleur est mise en oeuvre de manière appropriée pour déterminer les pertes du deuxième moteur.

**8.** Onduleur selon la revendication 7,
**caractérisé en ce que**

la fonction caractéristique est stockée dans une mémoire de l'électronique de signal de l'onduleur
et l'onduleur présente un moyen d'enregistrement de la tension de circuit intermédiaire de l'onduleur.

**9.** Procédé selon l'une quelconque des revendications 1 à 6,
**caractérisé en ce que**
les pertes déterminées en fonction de la tension de circuit intermédiaire enregistrée de l'onduleur sont utilisées dans un modèle de température du pilotage de moteur de l'onduleur.